# EUROPEAN PATENT APPLICATION

(11) **EP 4 404 436 A1**
(43) Date of publication of application: **24.07.2024**
(21) Application number: 22869824.7
(22) Date of filing: 01.09.2022
(51) Int. Cl.: H02K 3/26, H01F 5/04, H05K 1/16

(54) **COIL SUBSTRATE, COIL SUBSTRATE FOR MOTOR, AND MOTOR**

(30) Priority: 15.09.2021 JP 2021149921
(71) Applicant: IBIDEN CO., LTD., Ogaki-shi, Gifu 503-8604 (JP)
(72) Inventor: HIRASAWA, Takahisa, Ogaki-shi, Gifu 503-8503 (JP); FURUNO, Takayuki, Ogaki-shi, Gifu 503-8503 (JP)
(74) Representative: Hoefer & Partner Patentanwälte mbB
(86) International application number: PCT/JP2022/033032
(87) International publication number: WO 2023/042677

(57) **Abstract**

Provided are: a coil board enabling a motor having stable performance to be obtained, a motor coil board formed by using the coil board, and a motor formed by using the motor coil board. A coil board of an embodiment comprises: a flexible board having a first face and a second face on the opposite side to the first face; and a coil formed by coil-shaped wiring provided on the first face and coil-shaped wiring provided on the second face. The coil board can be formed into a substantially cylindrical shape by being wound in a circumferential direction about an axis extending in an orthogonal direction orthogonal to a longitudinal direction of the flexible board, starting from a reference side at one end of the flexible board in the longitudinal direction. The wiring comprises orthogonal portions extending along the orthogonal direction. The orthogonal portions include first orthogonal portions on the first face and second orthogonal portions on the second face. At least one slit is formed along the orthogonal direction in at least one of the first orthogonal portions and the second orthogonal portions.

## Description

### Technical Field

The technology disclosed in the present specification relates to a coil board, a motor coil board formed by using the coil board, and a motor formed by using the motor coil board.

### Background Art

Patent Document 1 describes a coil board comprising a flexible board and spiral-shaped wiring formed on both surfaces of the flexible board. A motor coil board is formed by winding the coil board into a cylindrical shape. A motor is formed by arranging the formed motor coil board on the inside of a cylindrical yoke, and arranging a rotary shaft and a magnet on the inside of the motor coil board.

### Prior Art Documents

### Patent Documents

Patent Document 1: JP 2020-61532 A

### Summary of the Invention

### [Problems in Patent Document 1]

In the technology of Patent Document 1, it is considered that the coil board is wound in a circumferential direction about an axis extending in an orthogonal direction (width direction) orthogonal to a longitudinal direction of the flexible board, starting from a side at one end of the flexible board in the longitudinal direction. That side also extends along the orthogonal direction. Orthogonal portions extending along the orthogonal direction may be provided in the wiring of the coil board in order to improve motor performance.

When the orthogonal portions are provided in the wiring, gap portions present between orthogonal portions also extend along the orthogonal direction. When the coil board has been wound in the circumferential direction as described above, it is thought that force will be readily applied and that folding will readily occur because there is no wiring present in the gap portions present between the orthogonal portions. As a result, it is thought that the motor coil board could be formed in a polygonal cylinder shape having a polygonal cross section (e.g., a polygonal cylinder shape having a cross section with around 4-12 sides), rather than a cylindrical shape with a circular cross section.

If the motor coil board is formed in a polygonal cylinder shape having a cross section with around 4-12 sides, it is thought that the motor coil board will interfere with the magnet which is arranged on the inside when the motor is formed. Furthermore, there is thought to be a reduction in heat dissipation because an interval between the motor coil board and the yoke is not constant. It is thought that stable motor performance cannot be demonstrated as a result.

### Means for Solving the Problems

A coil board according to the present invention comprises: a flexible board having a first face and a second face on the opposite side to the first face; and a coil formed by coil-shaped wiring provided on the first face and coil-shaped wiring provided on the second face. The coil board can be formed into a substantially cylindrical shape by being wound in a circumferential direction about an axis extending in an orthogonal direction orthogonal to a longitudinal direction of the flexible board, starting from a reference side at one end of the flexible board in the longitudinal direction. The wiring comprises orthogonal portions extending along the orthogonal direction. The orthogonal portions include first orthogonal portions on the first face and second orthogonal portions on the second face. At least one slit is formed along the orthogonal direction in at least one of the first orthogonal portions and the second orthogonal portions.

In a coil board according to an embodiment of the present invention, the at least one slit is formed along the orthogonal direction in at least one of the first orthogonal portions and the second orthogonal portions. When the coil board has been wound in the circumferential direction, the orthogonal portions are capable of bending at the position where the slit is formed. As a result, when the coil board has been wound in the circumferential direction, a motor coil board can be formed into a cylindrical shape having a substantially circular cross section. Consequently, the motor coil board is prevented from interfering with a magnet which is arranged on the inside of the motor coil board when a motor is formed. Furthermore, high heat dissipation is achieved because an interval between the motor coil board and a yoke is constant. When a motor is formed using the coil board of the embodiment, a motor having stable performance can therefore be obtained.

A motor coil board of the present invention is formed by winding the coil board of the present invention into a substantially cylindrical shape. The first face is arranged on an inner circumferential side and the second face is arranged on an outer circumferential side.

As described above, the motor coil board according to an embodiment of the present invention can be formed into a cylindrical shape having a substantially circular cross section. Interference between the magnet and the motor coil board when a motor is formed is prevented. High heat dissipation is achieved. When a motor is formed using the motor coil board of the embodiment, a motor having stable performance can therefore be obtained.

A motor of the present invention is formed by arranging the motor coil board of the present invention on the inside of a cylindrical yoke, and arranging a rotary shaft and a magnet on the inside of the motor coil board.

In a motor according to an embodiment of the present invention, interference between the magnet and the motor coil board is prevented. Furthermore, high heat dissipation is achieved because the interval between the motor coil board and the yoke is constant. A motor having stable performance can be obtained.

### Brief Description of the Drawings

[Fig. 1] is a plan view schematically showing a coil board according to an embodiment.
[Fig. 2] is a bottom view schematically showing the coil board according to an embodiment.
[Fig. 3] is an enlarged explanatory diagram schematically showing a portion of first orthogonal portions.
[Fig. 4] is an enlarged explanatory diagram schematically showing a portion of second orthogonal portions.
[Fig. 5] is a view in cross section schematically showing a portion of the coil board according to an embodiment.
[Fig. 6] is an oblique view schematically showing a motor coil board according to an embodiment.
[Fig. 7] is a view in cross section schematically showing a motor according to an embodiment.
[Fig. 8] is a plan view schematically showing a coil board according to a first modified example.
[Fig. 9] is a bottom view schematically showing the coil board according to the first modified example.
[Fig. 10] is a view in cross section schematically showing a portion of the coil board according to the first modified example.

### Embodiments of the Invention

### [Embodiments]

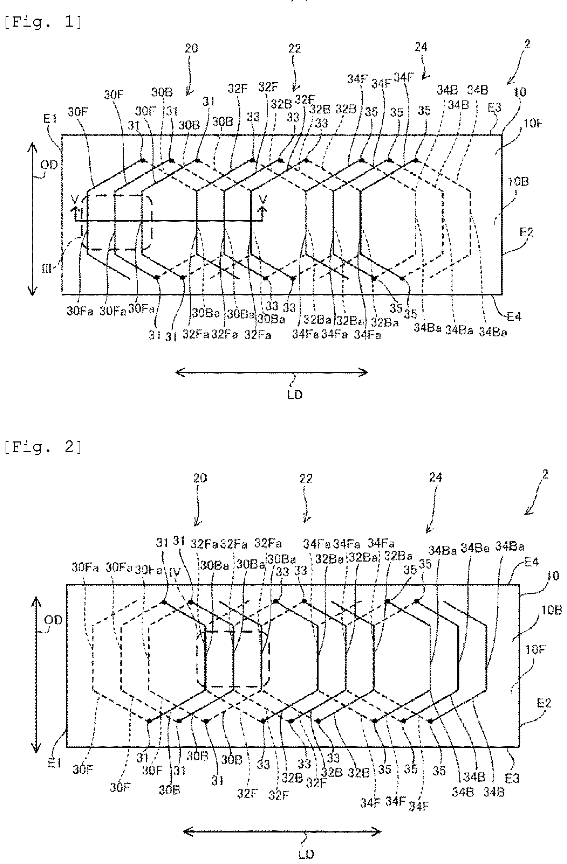

Fig. 1 is a plan view showing a coil board 2 according to an embodiment. Fig. 2 is a bottom view showing the coil board 2 according to an embodiment. The coil board 2 comprises a flexible board 10 and three coils 20, 22, 24.

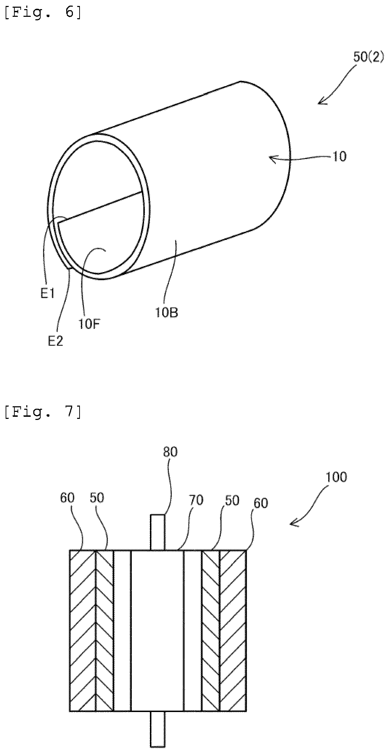

The flexible board 10 is a resin board comprising a first face 10F and a second face 10B on the opposite side to the first face 10F. The flexible board 10 is formed by using an insulating resin such as polyimide or polyamide. The flexible board 10 is capable of flexing. The flexible board 10 is formed in a rectangular shape with four sides, which are a first side E1 to a fourth side E4. The first side E1 is a short side at one end of the flexible board 10 in a longitudinal direction (direction of the arrow LD in fig. 1). The second side E2 is a short side at the other end in the longitudinal direction. The first side E1 and the second side E2 are both short sides extending along an orthogonal direction (direction of the arrow OD in fig. 1) which is orthogonal to the longitudinal direction. The third side E3 and the fourth side E4 are both long sides extending along the longitudinal direction. When the coil board 2 is wound into a substantially cylindrical shape to form a motor coil board 50 (see fig. 6), as will be described in detail later, the first side 10F is arranged on an inner circumferential side and the second face 10B is arranged on an outer circumferential side.

The coils 20, 22, 24 are aligned along the longitudinal direction of the flexible board 10. The three coils 20, 22, 24 may respectively constitute a U phase, V phase and W phase of a three-phase motor. The three coils 20, 22, 24 are aligned in that order from the first side E1 toward the second side E2. In a modified example, fewer than three coils may be provided on the flexible board 10, or four or more coils may be provided thereon.

In order to form the coil 20, first wiring 30F constituting a half turn of one turn is formed on the first face 10F side, second wiring 30B constituting a remaining half turn is formed on the second face 10B side, and adjacent turns are arranged offset from each other. In fig. 1 and 2, the coil 20 comprises three turns of wiring. The first wiring 30F and the second wiring 30B constituting each turn are electrically connected through via conductors 31 penetrating the flexible board 10. The first wiring 30F has first orthogonal portions 30Fa extending along the orthogonal direction (see the arrow OD). The second wiring 30B also has second orthogonal portions 30Ba extending along the orthogonal direction.

In the same way, in order to form the coil 22, first wiring 32F constituting a half turn of one turn is formed on the first face 10F side, second wiring 32B constituting a remaining half turn is formed on the second face 10B side, and adjacent turns are arranged offset from each other. The coil 22 comprises three turns of wiring. The first wiring 32F and the second wiring 32B constituting each turn are electrically connected through via conductors 33. The first wiring 32F has first orthogonal portions 32Fa extending along the orthogonal direction (see the arrow OD). The second wiring 32B also has second orthogonal portions 32Ba extending along the orthogonal direction.

In order to form the coil 24, first wiring 34F constituting a half turn of one turn is formed on the first face 10F side, second wiring 34B constituting a remaining half turn is formed on the second face 10B side, and adjacent turns are arranged offset from each other. The coil 24 comprises three turns of wiring. The first wiring 34F and the second wiring 34B constituting each turn are electrically connected through via conductors 35. The first wiring 34F has first orthogonal portions 34Fa extending along the orthogonal direction (see the arrow OD). The second wiring 34B also has second orthogonal portions 34Ba extending along the orthogonal direction.

As shown in fig. 1 and 2, the second orthogonal portions 30Ba of the second wiring 30B constituting the coil 20 overlap, through the flexible board 10, the first orthogonal portions 32Fa of the first wiring 32F constituting the adjacent coil 22. The second orthogonal portions 32Ba of the second wiring 32B constituting the coil 22 overlap, through the flexible board 10, the first orthogonal portions 32Fa of the first wiring 34F constituting the adjacent coil 24. The arrangement of the coils 20, 22, 24 in fig. 1 and 2 is purely an example. In another modified example, the second orthogonal portions 30Ba of the second wiring 30B constituting the coil 20 need not overlap the first orthogonal portions 32Fa of the first wiring 32F constituting the immediately adjacent coil 22, provided that they overlap the first orthogonal portions of first wiring constituting another coil (e.g., the first orthogonal portions of the first wiring of the coil third along). In the same way, the second orthogonal portions 32Ba of the second wiring 32B need not overlap the first orthogonal portions 34Fa of the first wiring 34F constituting the immediately adjacent coil 24, provided that they overlap the first orthogonal portions of first wiring constituting another coil (e.g., the first orthogonal portions of the first wiring of the coil third along).

Furthermore, the first face 10F and the first wiring 30F, 32F, 34F are covered over by a resin insulating layer, although this is not shown in the drawings. The second face 10B and the second wiring 30B, 32B, 34B are likewise covered over by a resin insulating layer.

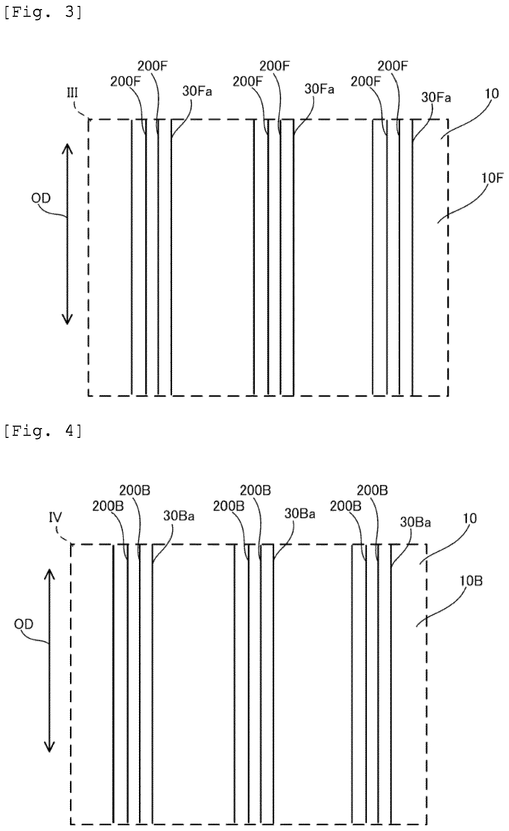

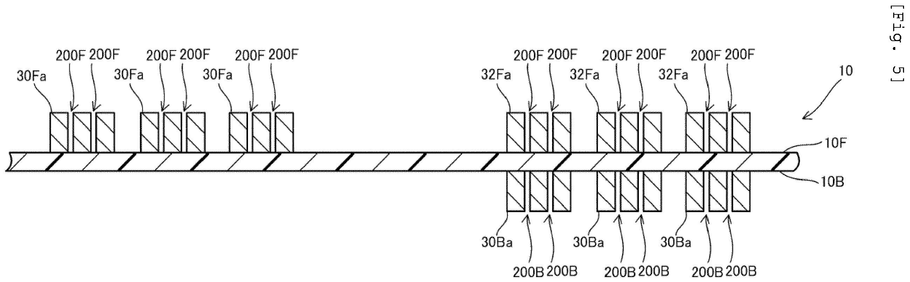

Fig. 3 is an enlarged explanatory diagram showing a portion of the first orthogonal portions 30Fa of the first wiring 30F. Fig. 3 is an enlargement of the part III in fig. 1. Fig. 4 is an enlarged explanatory diagram showing a portion of the second orthogonal portions 30Ba of the second wiring 30B. Fig. 4 is an enlargement of the part IV in fig. 1. Fig. 5 is a view in the cross section between V-V in fig. 1.

As shown in fig. 3 and 5, two slits 200F are formed along the orthogonal direction in the first orthogonal portions 30Fa. The slits 200F are formed along the entire length of the first orthogonal portions 30Fa. As shown in fig. 5, the slits 200F are formed with a depth reaching from an upper surface of the first orthogonal portions 30Fa to the first face 10F. As shown in fig. 5, two slits 200F are also formed in the first orthogonal portions 32Fa of the first wiring 32F in the same way as for the first orthogonal portions 30Fa. Two identical slits 200F are also formed in the first orthogonal portions 34Fa of the first wiring 34F, although these are not depicted. In a modified example, one slit 200F may be formed in the first orthogonal portions 30Fa, 32Fa, 34Fa, or three or more slits 200F may be formed.

Furthermore, slits are not formed in parts of the first wiring 30F, 32F, 34F other than the first orthogonal portions 30Fa, 32Fa, 34Fa.

As shown in fig. 4 and 5, two slits 200B are formed along the orthogonal direction in the second orthogonal portions 30Ba. The slits 200B are formed along the entire length of the second orthogonal portions 30Ba. As shown in fig. 5, the slits 200B are formed with a depth reaching from an upper surface of the second orthogonal portions 30Ba to the second face 10B. Two identical slits 200B are also formed in the second orthogonal portions 32Ba of the second wiring 32B and in the second orthogonal portions 34Ba of the second wiring 34B, although these are not depicted. In a modified example, one slit 200B may be formed in the second orthogonal portions 30Ba, 32Ba, 34Ba, or three or more slits 200B may be formed.

Furthermore, slits are not formed in parts of the second wiring 30B, 32B, 34B other than the second orthogonal portions 30Ba, 32Ba, 34Ba.

Fig. 6 is an oblique view schematically showing a motor coil board 50 employing the coil board 2 of the embodiment (fig. 1-5). As shown in fig. 6, the substantially cylindrical motor coil board 50 is formed as a result of the coil board 2 of the embodiment (fig. 1-5) being wound multiple times in a circumferential direction about an axis extending in the orthogonal direction (an axis extending parallel to the first side E1), starting from the first side E1 (fig. 1). When the coil board 2 is wound, the first face 10F of the flexible board 10 is arranged on the inner circumferential side, and the second face 10B is arranged on the outer circumferential side.

As described above, in the coil board 2 of the embodiment, the two slits 200F are formed along the orthogonal direction in each of the first orthogonal portions 30Fa, 32Fa, 34Fa. The two slits 200B are formed along the orthogonal direction in each of the second orthogonal portions 30Ba, 32Ba, 34Ba. When the coil board 2 has been wound in the circumferential direction, the first orthogonal portions 30Fa, 32Fa, 34Fa and the second orthogonal portions 30Ba, 32Ba, 34Ba are therefore capable of bending at the positions where the slits 200F, 200B are formed. As a result, when the coil board 2 has been wound in the circumferential direction, the motor coil board 50 can be formed into a cylindrical shape having a substantially circular cross section. To be more specific, according to the embodiment, the motor coil board 50 is formed with a polygonal cylinder shape (i.e., a substantially cylindrical shape) having a cross-sectional shape with at least 48 sides (more preferably at least 120 sides). The number of sides in the cross-sectional shape of the motor coil board 50 may vary according to factors such as the diameter of the motor coil board 50, the number of windings, and the number of coils. In such cases also, the cross-sectional shape of the motor coil board 50 should be a polygonal shape with at least 48 sides.

Fig. 7 is a view in cross section schematically showing a motor 100 employing the motor coil board 50 of the embodiment (fig. 6). The motor 100 is formed by arranging the motor coil board 50 on the inside of a yoke 60, and arranging a rotary shaft 80 and a magnet 70, which is fixed to the rotary shaft 80, on the inside of the motor coil board 50. As described above, the motor coil board 50 of the embodiment is formed with a substantially cylindrical shape (a polygonal shape having a cross-sectional shape with at least 48 sides). Consequently, the motor coil board 50 is prevented from interfering with the magnet 70 arranged on the inside of the motor coil board 50 when the motor 100 is formed. Furthermore, high heat dissipation is achieved because an interval between the motor coil board 50 and the yoke 60 is constant. When the motor 100 is formed using the coil board 2 of the embodiment, a motor 100 having stable performance can therefore be obtained. The first side E1 is an example of a "reference side". The first orthogonal portions 30Fa, 32Fa, 34Fa and the second orthogonal portions 30Ba, 32Ba, 34Ba are an example of "orthogonal portions".

### [Different example 1 of the embodiment]

In a coil board 2 according to different example 1 of the embodiment, the slits 200F are formed only in the first orthogonal portions 30Fa, 32Fa, 34Fa, and slits are not formed in the second orthogonal portions 30Ba, 32Ba, 34Ba.

### [Different example 2 of the embodiment]

In a coil board 2 according to different example 2 of the embodiment, the slits 200B are formed only in the second orthogonal portions 30Ba, 32Ba, 34Ba, and slits are not formed in the first orthogonal portions 30Fa, 32Fa, 34Fa.

### [Different example 3 of the embodiment]

In a coil board 2 according to different example 3 of the embodiment, slits identical to the slits 200F of the first orthogonal portions 30Fa, 32Fa, 34Fa are also formed in parts of the first wiring 30F, 32F, 34F other than the first orthogonal portions 30Fa, 32Fa, 34Fa. In the same way, slits identical to the slits 200B of the second orthogonal portions 30Ba, 32Ba, 34Ba are also formed in parts of the second wiring 30B, 32B, 34B other than the second orthogonal portions 30Ba, 32Ba, 34Ba.

### [Different example 4 of the embodiment]

In a coil board 2 according to different example 4 of the embodiment, none of the first orthogonal portions 30Fa, 32Fa, 34Fa or the second orthogonal portions 30Ba, 32Ba, 34Ba is overlapping in a cross section of the first orthogonal portions 30Fa, 32Fa, 34Fa, the flexible board 10, and the second orthogonal portions 30Ba, 32Ba, 34Ba.

### [First modified example of the embodiment]

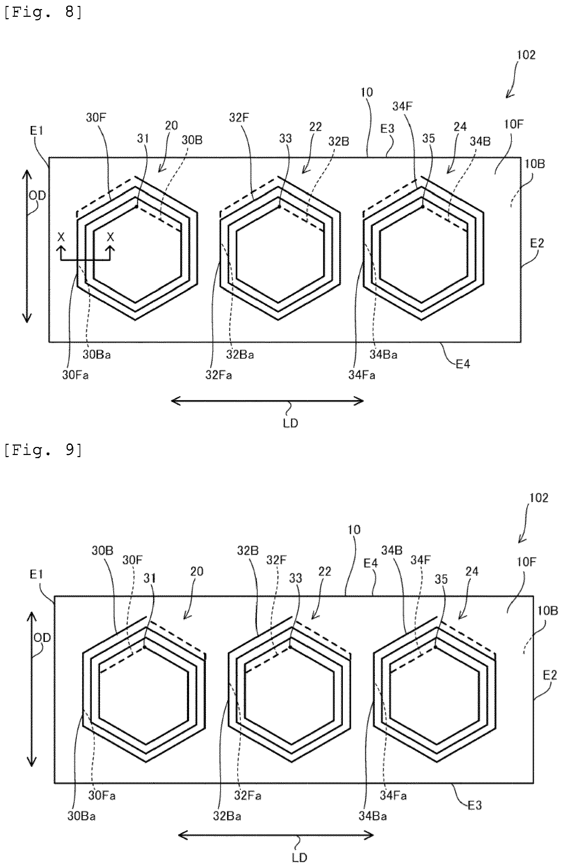

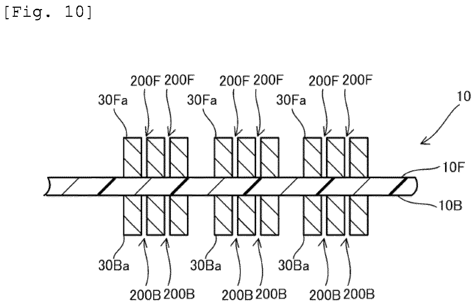

Fig. 8-10 show a first modified example of the embodiment. In the first modified example, the arrangement of the wiring constituting the coils 20, 22, 24 differs from that of the embodiment. Fig. 8 is a plan view showing a coil board 102 according to the first modified example. Fig. 9 is a bottom view showing the coil board 102 according to the first modified example. Fig. 10 is a view in the cross section between X-X in fig. 8.

A coil 20 comprises: coil-shaped first wiring 30F (fig. 8) provided on the first face 10F; and coil-shaped second wiring 30B (fig. 9) provided on the second face 10B. The first wiring 30F and the second wiring 30B are electrically connected through a via conductor 31 penetrating the flexible board 10. In the same way, a coil 22 comprises first wiring 32F and second wiring 32B. The first wiring 32F and the second wiring 32B are electrically connected through a via conductor 33. A coil 24 comprises first wiring 34F and second wiring 34B. The first wiring 34F and the second wiring 34B are electrically connected through a via conductor 35.

As shown in fig. 8, the first wiring 30F is formed in a spiral shape (hexagonal spiral shape) winding clockwise from the outer circumference toward the inner circumference. The via conductor 31 is formed at an inner circumferential end of the first wiring 30F. As shown in fig. 9, the second wiring 30B is formed in a spiral shape (hexagonal spiral shape) winding counterclockwise from the outer circumference toward the inner circumference. The via conductor 31 is formed at an inner circumferential end of the second wiring 30B. The first wiring 30F and the second wiring 30B are formed in spiral shapes with the same winding direction when seen from the same face. The first wiring 30F and the second wiring 30B function as one coil 20 in which they are electrically connected in series.

The first wiring 32F and second wiring 32B and the first wiring 34F and second wiring 34B have the same relationship as that of the first wiring 30F and second wiring 30B. The first wiring 32F and second wiring 32B are formed in spiral shapes with the same winding direction when seen from the same face. The first wiring 32F and the second wiring 32B function as one coil 22 in which they are electrically connected in series. The first wiring 34F and second wiring 34B are formed in spiral shapes with the same winding direction when seen from the same face. The first wiring 34F and the second wiring 34B function as one coil 24 in which they are electrically connected in series.

As shown in fig. 8 and 9, in the first modified example also, the first wiring 30F, 32F, 34F has the first orthogonal portions 30Fa, 32Fa, 34Fa extending along the orthogonal direction (see the arrow OD). The second wiring 30B, 32B, 34B also has the second orthogonal portions 30Ba, 32Ba, 34Ba extending along the orthogonal direction (see the arrow OD). The first orthogonal portion 30Fa overlaps the second orthogonal portion 30Ba (see fig. 10). The first orthogonal portion 32Fa overlaps the second orthogonal portion 32Ba. The first orthogonal portion 34Fa overlaps the second orthogonal portion 34Ba.

Furthermore, the first face 10F and the first wiring 30F, 32F, 34F are covered over by a resin insulating layer, although this is not shown in the drawings. The second face 10B and the second wiring 30B, 32B, 34B are likewise covered over by a resin insulating layer.

As shown in fig. 10, two slits 200F are formed along the orthogonal direction in the first orthogonal portions 30Fa. The slits 200F are formed along the entire length of the first orthogonal portions 30Fa. The slits 200F are formed with a depth reaching from an upper surface of the first orthogonal portions 30Fa to the first face 10F. Two identical slits 200F are also formed in the first orthogonal portions 32Fa of the first wiring 32F and in the first orthogonal portions 34Fa of the first wiring 34F, although these are not depicted. In a modified example, one slit 200F may be formed in the first orthogonal portions 30Fa, 32Fa, 34Fa, or three or more slits 200F may be formed. Furthermore, slits are not formed in parts of the first wiring 30F, 32F, 34F other than the first orthogonal portions 30Fa, 32Fa, 34Fa.

As shown in fig. 10, two slits 200B are formed along the orthogonal direction in the second orthogonal portions 30Ba. The slits 200B are formed along the entire length of the second orthogonal portions 30Ba. The slits 200B are formed with a depth reaching from an upper surface of the second orthogonal portions 30Ba to the second face 10B. Two identical slits 200B are also formed in the second orthogonal portions 32Ba of the second wiring 32B and in the second orthogonal portions 34Ba of the second wiring 34B, although these are not depicted. In a modified example, one slit 200B may be formed in the second orthogonal portions 30Ba, 32Ba, 34Ba, or three or more slits 200B may be formed. Furthermore, slits are not formed in parts of the second wiring 30B, 32B, 34B other than the second orthogonal portions 30Ba, 32Ba, 34Ba.

When a motor coil board 50 is formed using the coil board 102 of the first modified example (fig. 8-10) also, the motor coil board 50 can be formed into a cylindrical shape having a substantially circular cross section. To be more specific, the motor coil board 50 is formed with a polygonal cylinder shape (i.e., a substantially cylindrical shape) having a cross-sectional shape with at least 48 sides (more preferably at least 120 sides). The motor coil board 50 is prevented from interfering with the magnet 70 when the motor 100 is formed. Furthermore, high heat dissipation is achieved. When the motor 100 is formed using the coil board 102 of the first modified example, a motor 100 having stable performance can therefore be obtained.

### [Different example 1 of first modified example]

In a coil board 102 according to a different example 1 of the first modified example, the slits 200F are formed only in the first orthogonal portions 30Fa, 32Fa, 34Fa, and slits are not formed in the second orthogonal portions 30Ba, 32Ba, 34Ba.

### [Different example 2 of first modified example]

In a coil board 102 according to different example 2 of the first modified example, the slits 200B are formed only in the second orthogonal portions 30Ba, 32Ba, 34Ba, and slits are not formed in the first orthogonal portions 30Fa, 32Fa, 34Fa.

### [Different example 3 of first modified example]

In a coil board 102 according to different example 3 of the first modified example, slits identical to the slits 200F of the first orthogonal portions 30Fa, 32Fa, 34Fa are also formed in parts of the first wiring 30F, 32F, 34F other than the first orthogonal portions 30Fa, 32Fa, 34Fa. In the same way, slits identical to the slits 200B of the second orthogonal portions 30Ba, 32Ba, 34Ba are also formed in parts of the second wiring 30B, 32B, 34B other than the second orthogonal portions 30Ba, 32Ba, 34Ba.

### [Different example 4 of first modified example]

In a coil board 102 according to different example 4 of the first modified example, the first wiring 30F, 32F, 34F and the second wiring 30B, 32B, 34B are arranged so as not to overlap through the flexible board 10. In different example 4, none of the first orthogonal portions 30Fa, 32Fa, 34Fa or the second orthogonal portions 30Ba, 32Ba, 34Ba is overlapping in a cross section of the first orthogonal portions 30Fa, 32Fa, 34Fa, the flexible board 10, and the second orthogonal portions 30Ba, 32Ba, 34Ba.

### Key to Symbols

2: Coil board
10: Flexible board
10F: First face
10B: Second face
20, 22, 24: Coil
30Fa, 32Fa, 34Fa: First orthogonal portion
30Ba, 32Ba, 34Ba: Second orthogonal portion
50: Motor coil board
60: Yoke
70: Magnet
80: Rotary shaft
100: Motor
102: Coil board
200F: Slit
200B: Slit

## Claims

1. A coil board comprising:
a flexible board having a first face and a second face on the opposite side to the first face; and
a coil formed by coil-shaped wiring provided on the first face and coil-shaped wiring provided on the second face,
wherein the coil board can be formed into a substantially cylindrical shape by being wound in a circumferential direction about an axis extending in an orthogonal direction orthogonal to a longitudinal direction of the flexible board, starting from a reference side at one end of the flexible board in the longitudinal direction,
the wiring comprises orthogonal portions extending along the orthogonal direction, the orthogonal portions including first orthogonal portions on the first face and second orthogonal portions on the second face, and
at least one slit is formed along the orthogonal direction in at least one of the first orthogonal portions and the second orthogonal portions.

2. The coil board of claim 1, wherein the slit is formed in either one of the first orthogonal portions and the second orthogonal portions.

3. The coil board of claim 1, wherein the slit is formed in both of the first orthogonal portions and the second orthogonal portions.

4. The coil board of claim 1, wherein the first orthogonal portions and the second orthogonal portions are overlapping in a cross section of the first orthogonal portions, the flexible board, and the second orthogonal portions.

5. A motor coil board formed by winding the coil board of claim 1 into a substantially cylindrical shape, wherein the first face is arranged on an inner circumferential side and the second face is arranged on an outer circumferential side.

6. The motor coil board of claim 5, which has a polygonal cylinder shape having a polygonal cross-sectional shape with at least 48 sides.

7. A motor formed by arranging the motor coil board of claim 5 on the inside of a cylindrical yoke, and arranging a rotary shaft and a magnet on the inside of the motor coil board.
